(19) **Europäisches Patentamt / European Patent Office / Office européen des brevets**

(11) **EP 4 443 382 A1**

(12) # EUROPEAN PATENT APPLICATION
published in accordance with Art. 153(4) EPC

(43) Date of publication:
**09.10.2024 Bulletin 2024/41**

(21) Application number: **23845011.8**

(22) Date of filing: **18.05.2023**

(51) International Patent Classification (IPC):
**G06T 5/00** (2024.01)   **G06T 5/10** (2006.01)
**G06N 3/04** (2023.01)   **G06N 3/08** (2023.01)

(86) International application number:
**PCT/CN2023/095109**

(87) International publication number:
**WO 2024/021796 (01.02.2024 Gazette 2024/05)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **25.07.2022 CN 202210876986**

(71) Applicant: **Tencent Technology (Shenzhen) Company Limited**
**Shenzhen, Guangdong, 518057 (CN)**

(72) Inventors:
- **ZHANG, Ruifen**
  **Shenzhen, Guangdong 518000 (CN)**
- **LIU, Luyan**
  **Shenzhen, Guangdong 518000 (CN)**
- **WANG, Hong**
  **Shenzhen, Guangdong 518000 (CN)**
- **HUANG, Yawen**
  **Shenzhen, Guangdong 518000 (CN)**
- **ZHENG, Yefeng**
  **Shenzhen, Guangdong 518000 (CN)**

(74) Representative: **Nederlandsch Octrooibureau**
**P.O. Box 29720**
**2502 LS The Hague (NL)**

(54) **IMAGE PROCESSING METHOD AND APPARATUS, ELECTRONIC DEVICE, STORAGE MEDIUM, AND PROGRAM PRODUCT**

(57) Embodiments of the present application provide an image processing method and apparatus, an electronic device, a storage medium, and a program product, which can be applied to scenarios such as cloud technology, artificial intelligence, intelligent transportation, and vehicle mounting. The method comprises: acquiring multiple pieces of corresponding undersampled frequency domain data by means of multiple radio frequency coils; then, performing information supplement operations on each of the multiple pieces of frequency domain data using multiple cascaded image processing networks, to obtain multiple corresponding target restored images, and determining a target reconstructed image on the basis of the multiple target restored images, each piece of frequency domain data being used to obtain one target restored image, and each image processing network comprising an image restoration network, a frequency domain completion network, and a sensitivity estimation network.

Obtain, by a plurality of receiving coils, corresponding undersampled initial data respectively — S201

Perform, by using a plurality of cascaded target processing networks, an information supplement operation respectively on the plurality of undersampled pieces of obtained initial data to obtain corresponding target restored images, and generate a target reconstructed image based on the plurality of obtained target restored images — S202

FIG. 2

**Description**

RELATED APPLICATION

This application is submitted based on Chinese Patent Application No. 202210876986.3 filed on July 25, 2022, and claims priority to the Chinese Patent Application.

FIELD OF THE TECHNOLOGY

Embodiments of this application relate to the field of artificial intelligence technologies, and in particular, to an image processing method and apparatus, an electronic device, a storage medium, and a program product.

BACKGROUND OF THE DISCLOSURE

With the development of medical technologies and the popularization of medical image capturing, medical images are now commonly used to learn the current health status of a patient. The magnetic resonance imaging technology (MRI) can provide high-quality reference information through high-resolution and high-contrast images. However, the MRI requires longer scanning time than other medical imaging technologies. Long scanning time may cause patient discomfort and may alternatively generate motion artifacts that affect the quality of MRI images.

In related art, undersampled K-space data is collected by a radio frequency coil according to a sampling mask, and then magnetic resonance imaging is reconstructed based on the undersampled K-space data. However, information may be missed in the undersampled K-space data, resulting in poor quality of MRI images reconstructed based on the undersampled K-space data.

SUMMARY

Embodiments of this application provide an image processing method and apparatus, an electronic device, a storage medium, and a program product, to improve quality of a reconstructed MRI image.

An embodiment of this application provides an image processing method, executable by an electronic device, the method including:

obtaining, by a plurality of radio frequency coils, a plurality of pieces of undersampled frequency-domain data respectively, each radio frequency coil being configured to obtain one piece of undersampled frequency-domain data;

performing, by using a plurality of cascaded image processing networks, an information supplement operation respectively on the plurality of pieces of undersampled frequency-domain data to obtain a plurality of corresponding target restored images, and generating a target reconstructed image based on the plurality of target restored images, each target restored image being obtained from a respective piece of frequency-domain data, and each of the cascaded image processing networks including an image restoring network, a frequency-domain complement network, and a susceptibility estimation network.

An embodiment of this application provides an image processing apparatus, including:

an obtaining module, configured to: obtain, by a plurality of radio frequency coils, a plurality of pieces of undersampled frequency-domain data respectively, each radio frequency coil being configured to obtain one piece of undersampled frequency-domain data; and

a processing module, configured to: perform, by using a plurality of cascaded image processing networks, an information supplement operation respectively on the plurality of pieces of obtained frequency-domain data to obtain a plurality of corresponding target restored images, and generate a target reconstructed image based on the plurality of target restored images, each target restored image being obtained from a respective piece of frequency-domain data, and each of the cascaded image processing networks including an image restoring network, a frequency-domain complement network, and a susceptibility estimation network.

An embodiment of this application provides a computer device, including a memory, a processor, and a computer program stored in the memory and executable on the processor, the processor, when executing the program, implementing operations of the foregoing image processing method.

An embodiment of this application provides a computer-readable storage medium, having a computer program stored thereon, the computer program being executable by a computer device, and the program, when run on the computer device, causing the computer device to perform operations of the foregoing image processing method.

An embodiment of this application provides a computer program product, including a computer program stored on a computer-readable storage medium, the computer program product including program instructions, and the program instructions, when executed by a computer device, causing the computer device to perform operations of the foregoing image processing method.

In embodiments of this application, an image is reconstructed from frequency-domain data by using a plurality of cascaded image processing networks. In a process of obtaining a target restored image, an image restoring network, a frequency-domain complement network, and a susceptibility estimation network in the plurality of image processing networks perform cross information supplement in dimensions of a frequency domain, an image domain, and susceptibility information, to obtain more comprehensive image information. In this way, a reconstructed image has a higher resolution and a higher signal-to-noise ratio, so that quality of a target reconstructed image is effectively improved.

BRIEF DESCRIPTION OF THE DRAWINGS

To describe the technical solutions of embodiments of this application more clearly, the following briefly describes the accompanying drawings required for describing embodiments. Apparently, the accompanying drawings in the following description show only some embodiments of this application, and a person of ordinary skill in the art may still derive other drawings from these accompanying drawings without creative efforts.

FIG. 1 is a schematic diagram of a structure of a system architecture according to an embodiment of this application.

FIG. 2 is a schematic flowchart of an image processing method according to an embodiment of this application.

FIG. 3 is a schematic diagram of a network structure according to an embodiment of this application.

FIG. 4 is a schematic diagram of a network structure according to an embodiment of this application.

FIG. 5 is a schematic diagram of a network structure according to an embodiment of this application.

FIG. 6 is a schematic diagram of a network structure according to an embodiment of this application.

FIG. 7 is a schematic diagram of a network structure according to an embodiment of this application.

FIG. 8 is a schematic diagram of a network structure according to an embodiment of this application.

FIG. 9 is a schematic diagram of a network structure according to an embodiment of this application.

FIG. 10A is a schematic flowchart of an image processing method according to an embodiment of this application.

FIG. 10B is a schematic diagram of a structure of an image processing apparatus according to an embodiment of this application.

FIG. 11 is a schematic diagram of a structure of a computer device according to an embodiment of this application.

DESCRIPTION OF EMBODIMENTS

To make the objectives, technical solutions, and beneficial effects of this application clearer, the following further describes this application in detail with reference to the accompanying drawings and embodiments. The specific embodiments described herein are merely used to explain this application but are not intended to limit this application.
For ease of understanding, terms in embodiments of this application are explained below.
Artificial intelligence (AI) is a theory, method, technology, and application system that use a digital computer or a machine controlled by the digital computer to simulate, extend, and expand human intelligence, perceive an environment, acquire knowledge, and use knowledge to obtain an optimal result. In other words, the artificial intelligence is a comprehensive technology in computer science and attempts to understand the essence of intelligence and produce a new intelligent machine that can react in a manner similar to human intelligence. The artificial intelligence is to study the design principles and implementation methods of various intelligent machines, to enable the machines to have the functions of perception, reasoning, and decision-making.
The artificial intelligence technology is a comprehensive discipline, and relates to a wide range of fields including both hardware-level technologies and software-level technologies. The basic artificial intelligence technologies generally include technologies such as a sensor, a dedicated artificial intelligence chip, cloud computing, distributed storage, a big data processing technology, an operating/interaction system, and electromechanical integration. Artificial intelligence software technologies mainly include several major directions such as a computer vision technology, a speech processing technology, a natural language processing technology, and machine learning/deep learning.

Machine learning (ML) is a multi-field interdiscipline, and relates to a plurality of disciplines such as the probability theory, statistics, the approximation theory, convex analysis, and the algorithm complexity theory. The machine learning specializes in studying how a computer simulates or implements a human learning behavior to obtain new knowledge or skills, and reorganize an existing knowledge structure, so as to keep improving its performance. The machine learning is the core of artificial intelligence, is a basic way to make the computer intelligent, and is applied to various fields of the artificial intelligence. The machine learning and deep learning generally include technologies such as an artificial neural network, a belief network, reinforcement learning, transfer learning, inductive learning, and learning from demonstrations. For example, in embodiments of this application, a magnetic resonance imaging (MRI) image is reconstructed by using the machine learning technology.

Magnetic resonance imaging: It is a medical imaging technology in which detailed images of organs and tissues within a body of an animal (such as a human being) are created by using radio waves generated by magnetic field and computers.

K-space: It is an extension of a Fourier space concept in MRI imaging. The K-space represents space frequency information in two dimensions or three dimensions of an object, and is defined by space covered by a phase and frequency encoding data.

K-space data: It is obtained by transforming an image from an image domain (that is, a time domain) to a frequency domain (K-space domain), and is a two-dimensional Fourier transform result of image data of the image domain. A number of data points in the K-space data is same as a number of pixel points restored by performing an inverse Fourier transform according to the K-space data. Each data point is a complex number, and is configured for describing an amplitude and a phase of a pixel point. An included angle between a real part and an imaginary part of the complex number is the phase, and a root of a sum of squares of the real part and the imaginary part is the amplitude. The inverse Fourier transform can be performed on the K-space data to restore the image. For example, when there are 1,024 data points in the K-space data, an image with a resolution of $32 \times 32$ ($1024 = 32 \times 32$) can be restored. When there are 4,096 data points in the K-space, an image with a resolution of $64 \times 64$ ($4096 = 64 \times 64$) can be restored.

A plurality of radio frequency coils: In multi-channel nuclear magnetic resonance imaging, each radio frequency coil obtains undersampled K-space data of a corresponding body part under guidance of a sampling mask. Because the undersampled K-space data is only partially sampled, scanning time is shortened. An MRI image is reconstructed from the undersampled K-space data collected respectively by all radio frequency coils.

Oversampling: It has a sampling frequency twice higher than the highest frequency of an electromagnetic wave signal emitted by a radio frequency coil, and this type of sampling is referred to as the oversampling.

Undersampling: It has a sampling frequency twice lower than the highest frequency of an electromagnetic wave signal emitted by a radio frequency coil, and this type of sampling is referred to as the undersampling.

Full sampling: It has a sampling frequency twice the highest frequency of an electromagnetic wave signal emitted by a radio frequency coil, and this type of sampling is referred to as the full sampling.

In a process of implementing embodiments of this application, it is found by the applicant that in related art, to save MRI scanning time, undersampled K-space data is collected concurrently by using a plurality of radio frequency coils according to a sampling mask, and then magnetic resonance imaging is reconstructed based on the undersampled K-space data. However, information may be missed in the undersampled K-space data, resulting in poor quality of MRI images reconstructed based on the undersampled K-space data.

It is found by the applicant through analysis that coil susceptibility can be used as supplementary information for information supplement on the undersampled K-space data. In addition, a deep learning method shows excellent performance in inverse problems of imaging such as denoising, compressed sensing, and super-resolution. Therefore, if the deep learning is used, multi-level information compensation is performed on the undersampled K-space data based on the coil susceptibility to obtain complementary K-space data. Then, a reconstructed MRI image is obtained based on the complementary K-space data, and the quality of the MRI image is effectively improved.

In view of this, embodiments of this application provide an image processing method, including: obtaining, by a plurality of radio frequency coils, a plurality of pieces of corresponding undersampled frequency-domain data respectively; and performing, by using a plurality of cascaded image processing networks, an information supplement operation respectively on the plurality of pieces of obtained frequency-domain data to obtain a plurality of corresponding target restored images, and determining a target reconstructed image based on the plurality of obtained target restored images, each radio frequency coil being configured to obtain one piece of undersampled frequency-domain data, and each of the cascaded image processing networks including an image restoring network, a frequency-domain complement network, a susceptibility estimation network.

The performing, by using a plurality of cascaded image processing networks, an information supplement operation respectively on the plurality of pieces of undersampled frequency-domain data to obtain a plurality of corresponding target restored images may be implemented in the following manners: performing the following operations on each piece of frequency-domain data in sequence according to a cascading order of the plurality of image processing networks: for the first image processing network, performing, by an image restoring network in a current cascade, image-domain information supplement on the frequency-domain data, and inputting an obtained restored image in the current cascade to a frequency-domain complement network in a next cascade for frequency-domain information supplement; and performing, by a frequency-domain complement network in the current cascade, frequency-domain information supplement on the frequency-domain data, and inputting obtained frequency-domain complement data in the current cascade to a susceptibility estimation network in the next cascade for susceptibility supplement; and for each non-first image processing network, performing, by an image restoring network in a current cascade, image-domain information supplement on frequency-domain complement data output by a frequency-domain complement network in a previous cascade and coil susceptibility output by a susceptibility estimation network in the previous cascade to obtain a restored image in the current cascade, and using the restored image in the current cascade output by an image processing network in the last cascade as the target reconstructed image.

In embodiments of this application, an information supplement operation is performed respectively on a plurality of pieces of obtained undersampled frequency-domain data by using a plurality of cascaded image processing networks to obtain corresponding target restored images, and a target reconstructed image is generated based on the plurality of obtained target restored images. In a process of obtaining the target restored images, an image restoring network, a frequency-domain complement network, and a susceptibility estimation network in the plurality of image processing networks perform cross information supplement in dimensions of an image domain, a frequency domain, and susceptibility information, to obtain more comprehensive image information. In this way, quality of the target reconstructed image is effectively improved when image reconstruction is performed based on the more comprehensive image information that is obtained.

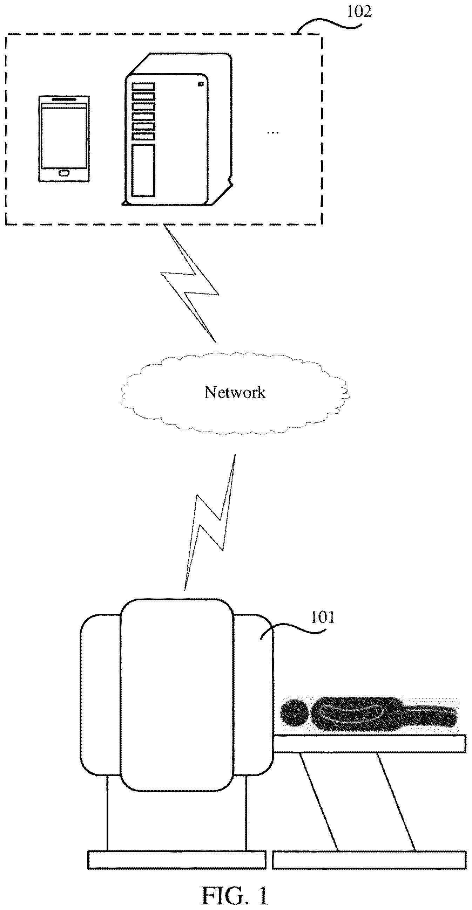

FIG. 1 is a diagram of a system architecture of an MRI system applicable to an embodiment of this application. The system architecture includes at least a signal collecting device 101 and an image reconstructing device 102.

The signal collecting device 101 includes a plurality of radio frequency (RF) coils. Each RF coil emits a RF signal to a human being or an animal, and receives an MR signal emitted from the human or the animal. Specifically, to induce an atomic nucleus to transfer from a low-energy state to a high-energy state, the RF coil generates an electromagnetic wave signal and applies the electromagnetic wave signal to a patient. The electromagnetic wave signal is a RF signal corresponding to a type of the atomic nucleus. When the electromagnetic wave signal generated by the RF coil is applied to the atomic nucleus, the atomic nucleus may transfer from the low-energy state to the high-energy state. Then, when the RF coil no longer generates an electromagnetic wave signal, the atomic nucleus that is in the body of the patient and that is previously applied the electromagnetic wave signal transfers from the high-energy state to the low-energy state, so that an electromagnetic wave signal having Larmor frequency is emitted, and the RF coil receives the electromagnetic wave signal released form the atomic nucleus of the body of the patient.

When the electromagnetic wave signal is received, the RF coil sends a RF signal sequence of part of discrete phases according to a sampling mask, to obtain undersampled K-space data, and sends the undersampled K-space data to the image reconstructing device 102.

The image reconstructing device 102 performs an information supplement operation respectively on a plurality of pieces of obtained undersampled K-space data by using a plurality of cascaded image processing networks to obtain a plurality of corresponding target restored images, and generate a target reconstructed image based on the plurality of obtained target restored images.

The foregoing image reconstructing device 102 may be a terminal device or a server. The terminal device may be a smart phone, a tablet computer, a notebook computer, a desktop computer, an intelligent voice interaction device, an intelligent vehicle-mounted device, and the like. The server may be an independent physical server, a server cluster or a distributed system including a plurality of physical servers, or a cloud server that provides a basic cloud computing service such as a cloud service, a cloud database, cloud computing, a cloud function, cloud storage, a network service, cloud communication, a middleware service, a domain name service, a security service, a content delivery network (CDN), and a big data and artificial intelligence platform. The signal collecting device 101 may be directly or indirectly connected to the image reconstructing device 102 via wired or wireless communications, which is not limited in embodiments of this application.

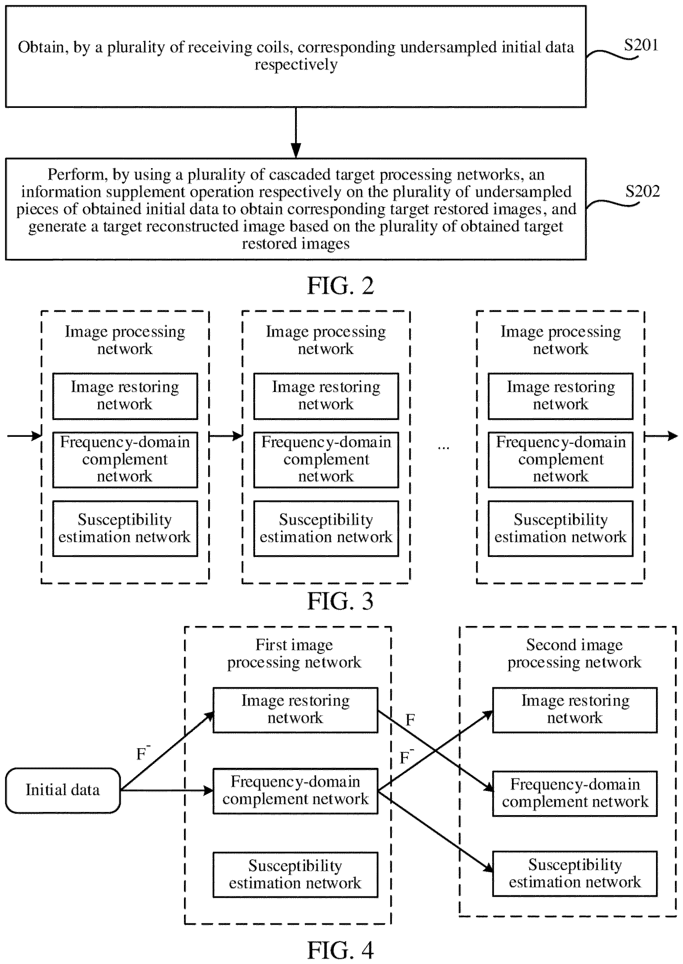

Based on the diagram of the system architecture shown in FIG. 1, an embodiment of this application provides a process of an image processing method, as shown in FIG. 2. The process of the method is performed by a computer device. The computer device may be the image reconstructing device 102 shown in FIG. 1. The method includes the following operations:

Step S201: Obtain, by a plurality of radio frequency coils, a plurality of pieces of undersampled frequency-domain data respectively.

Each radio frequency coil is configured to obtain one piece of undersampled frequency-domain data. Specifically, the following processing is performed by each radio frequency coil: directly collecting, by the radio frequency coil, undersampled K-space data to be used as a piece of undersampled frequency-domain data; or collecting fully-sampled K-space data by the radio frequency coil, performing undersampling processing by adding a mask in the fully-sampled K-space data, and using the obtained undersampled K-space data as a piece of undersampled frequency-domain data.

Step S202: Perform, by using a plurality of cascaded image processing networks, an information supplement operation respectively on the plurality of pieces of obtained frequency-domain data to obtain a plurality of corresponding target restored images, and generate a target reconstructed image based on the plurality of obtained target restored images.

Each piece of frequency-domain data includes undersampled K-space data obtained when a radio frequency coil performs scanning once on a human being or an animal. One piece of frequency-domain data includes a plurality of data points that may be configured for reconstructing a two-dimensional image of a scanned part of the human being or the animal, that is, the target restored image. The plurality of target restored images are configured for synthesizing a three-dimensional image of the scanned part, that is, the target reconstructed image. Various solutions provided in related art may be used to perform synthesis from two dimensions to three dimensions, for example, a surface rendering technology.

Specifically, a network structure formed by the plurality of image processing networks is shown in FIG. 3. Each image processing network includes an image restoring network, a frequency-domain complement network, and a susceptibility estimation network. The undersampled K-space data, the restored image, and coil susceptibility are in a form of complex numbers. Each of input layers of the image restoring network, the frequency-domain complement network, and the susceptibility estimation network is provided with two input channels, which are an imaginary part input channel and a real part input channel. The image restoring network, the frequency-domain complement network, and the susceptibility estimation network may be a fully convolutional network such as a U-Net, or may be a network in another form, which is not limited in embodiments of this application. In addition, the foregoing step S201 and step S202 are a process of processing frequency-domain data obtained by a group (slice) of radio frequency coils to obtain a target reconstructed image. The foregoing step S201 and step S202 are repeatedly performed to process frequency-domain data obtained by another group (slice) of radio frequency coils to obtain a target reconstructed image corresponding to the another group of radio frequency coils. Then, a three-dimensional MRI image is obtained based on a target reconstructed image corresponding to the plurality of radio frequency coils.

A process of the first image processing network processing frequency-domain data is described below with reference to the network structure shown in FIG. 3, as shown in FIG. 4.

For the first image processing network, image-domain information supplement is performed on undersampled frequency-domain data (that is, undersampled K-space data, which is referred to as frequency-domain data below) by an image restoring network in a current cascade, and an obtained restored image in the current cascade is input to a frequency-domain complement network in a next cascade for frequency-domain information supplement. Then, frequency-domain information supplement is performed on the frequency-domain data by a frequency-domain complement network in the current cascade, and obtained frequency-domain complement data in the current cascade is input to a susceptibility estimation network in the next cascade for susceptibility supplement.

Specifically, an inverse Fourier transform ($F^-$) is performed on the frequency-domain data to obtain an initial time-domain image. Then, image-domain information supplement is performed on the initial time-domain image by the image restoring network in the first image processing network to obtain the restored image in the current cascade. A Fourier transform (F) is performed on the restored image in the current cascade to obtain frequency-domain data corresponding to the restored image, and the frequency-domain data corresponding to the restored image is input to the frequency-domain complement network in the next cascade (a frequency-domain complement network in the second image processing network) for frequency-domain information supplement.

The undersampled frequency-domain data is the undersampled K-space data. Therefore, the frequency-domain data may be directly input to the frequency-domain complement network in the first image processing network for the frequency-domain information supplement to obtain the frequency-domain complement data in the current cascade. The frequency-domain complement data in the current cascade is input to the susceptibility estimation network in the next cascade (a susceptibility estimation network in the second image processing network) for the susceptibility supplement. In addition, after the inverse Fourier transform is performed on the frequency-domain complement data in the current cascade, a time-domain image corresponding to the frequency-domain complement data is obtained, and the time-domain image corresponding to the frequency-domain complement data is input to an image restoring network in the next cascade (that is, an image restoring network in the second image processing network) for the image-domain information supplement.

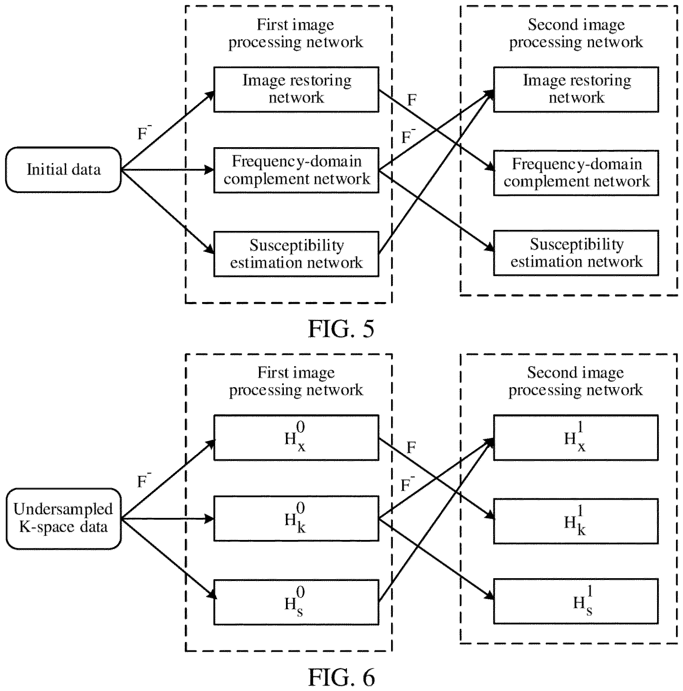

In the embodiments of the present disclosure including the embodiments of both the claims and the specification (hereinafter referred to as "all embodiments of the present disclosure"), as shown in FIG. 5, for the first image processing network, target data within a preset frequency range is selected from the frequency-domain data, and an inverse Fourier transform ($F^-$) is performed on the target data to obtain initial coil susceptibility. Susceptibility supplement is performed on the initial coil susceptibility by a susceptibility estimation network in the current cascade, and obtained coil susceptibility in the current cascade is input to the frequency-domain complement network in the next cascade for frequency-domain information supplement.

Specifically, data lower than the preset frequency is selected from the undersampled K-space data to be used as the target data. Then, the inverse Fourier transform is performed on the target data to obtain a time-domain image corresponding to the target data to be used as the initial coil susceptibility in a form of images. In addition, the susceptibility supplement is performed on the initial coil susceptibility by the susceptibility estimation network in the first image processing network to obtain coil susceptibility in the current cascade in a form of images. The coil susceptibility is input to the frequency-domain complement network in the next cascade (that is, the frequency-domain complement network in the second image processing network) for the frequency-domain information supplement.

For example, as shown in FIG. 6, the first image processing network includes an image restoring network $H_x^0$, a frequency-domain complement network Hk, and a susceptibility estimation network $H_s^0$. The second image processing network includes an image restoring network $H_x^1$, a frequency-domain complement network Hk, and a susceptibility estimation network $H_s^1$.

An inverse Fourier transform ($F^-$) is performed on undersampled K-space data to obtain a time-domain image corresponding to the undersampled K-space data. Zero is filled in the time-domain image corresponding to the undersampled K-space data (for example, 0 is filled around a 32 × 32 time-domain image to obtain a 40 × 40 zero-filled image) to obtain a zero-filled image (that is, an initial time-domain image). Frequency-domain data corresponding to the zero-fill image is smoother than frequency-domain data corresponding to the time-domain image before zero filling.

Then, image-domain information supplement is performed on the zero-filled image by the image restoring network $H_x^0$ to obtain a restored image in a current cascade. A Fourier transform is performed on the restored image in the current cascade to obtain frequency-domain data corresponding to the restored image, and the frequency-domain data corresponding to the restored image is input to the frequency-domain complement network Hk in the second image processing network.

The undersampled K-space data is input to the frequency-domain complement network Hk to obtain frequency-domain complement data in the current cascade. The frequency-domain complement data in the current cascade is input to the susceptibility estimation network $H_s^1$, in the second image processing network, and an inverse Fourier transform ($F^-$) is performed on the frequency-domain complement data in the current cascade, then the frequency-domain complement data in the current cascade is input to the image restoring network $H_x^1$ in the second image processing network.

Target frequency-domain data lower than a preset frequency is selected from the undersampled K-space data. Then, an inverse Fourier transform ($F^-$) is performed on the target frequency-domain data to obtain a time-domain image corresponding to the target frequency-domain data, and the time-domain image corresponding to the target frequency-domain data is used as initial coil susceptibility in a form of images. In addition, susceptibility supplement is performed on the initial coil susceptibility by the susceptibility estimation network $H_s^0$ in the first image processing network to obtain coil susceptibility in the current cascade in a form of images. The coil susceptibility in the current cascade is input to the image restoring network $H_x^1$ in the second image processing network.

In embodiments of this application, frequency-domain information supplement is performed on undersampled K-space data by using a frequency-domain complement network, image-domain information supplement is performed on the undersampled K-space data by using an image restoring network, and coil susceptibility supplement is performed on the undersampled K-space data by using a susceptibility estimation network, to implement information supplement on multi-dimensions of a frequency domain and an image domain, so as to obtain more complete K-space data. In this way, quality of a reconstructed image can be effectively improved when image reconstruction is performed based on the complete K-space data.

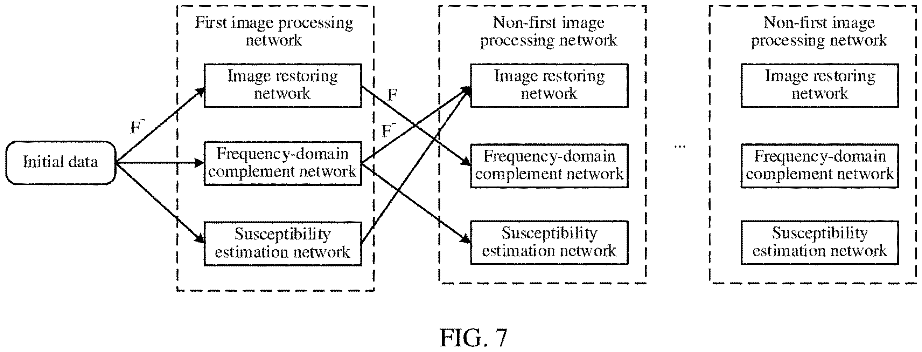

A process of a non-first image processing network processing frequency-domain data with reference to the network structure shown in FIG. 3, as shown in FIG. 7, which includes the following operations:

performing, by an image restoring network in a current cascade, image-domain information supplement on frequency-domain complement data output by a frequency-domain complement network in a previous cascade and coil susceptibility output a susceptibility estimation network in the previous cascade to obtain a restored image in the current cascade; performing, by a frequency-domain complement network in the current cascade, frequency-domain information supplement on a restored image output by an image restoring network in the previous cascade to obtain frequency-domain complement data in the current cascade; and performing, by a susceptibility estimation network in the current cascade, susceptibility supplement on the frequency-domain complement data output by the frequency-domain complement network in the previous cascade to obtain coil susceptibility in the current cascade.

7

Specifically, an inverse Fourier transform and a shrinking operation are performed on the frequency-domain complement data output by the frequency-domain complement network in the previous cascade to obtain a time-domain image. For example, an inverse Fourier transform is performed on the frequency-domain complement data (that is, the frequency-domain complement data output by the frequency-domain complement network in the previous cascade) to obtain a time-domain image corresponding to the frequency-domain complement data, and a shrinking operation is performed on the time-domain image corresponding to the frequency-domain complement data to obtain a time-domain image after the shrinking operation.

Then, the image-domain information supplement is performed, by the image restoring network in the current cascade, on the time-domain image after the shrinking operation and the coil susceptibility output by the susceptibility estimation network in the previous cascade to obtain the restored image in the current cascade. If the image restoring network in the current cascade is the last image processing network, the restored image in the current cascade is used as a target restored image for a reconstructed image. If the image restoring network in the current cascade is not located in the last image processing network, a Fourier transformed (F) is performed on the restored image in the current cascade, and then restored image in the current cascade is input to a frequency-domain complement network in a next image processing network for the frequency-domain information supplement.

A formula of the shrinking operation $\mathcal{R}$ is as follows:

$$\mathcal{R}(x_1, \ldots, x_N) = \sum_i S_i^* x_i \ldots \ldots \ldots \ldots (1)$$

$x_1, \ldots, x_N$ are the time-domain images obtained by performing the inverse Fourier transform on the frequency-domain complement data. $S_i$ is susceptibility of an i$^{th}$ radio frequency coil. $S_i^*$ is a conjugate complex number of $S_i$.

A Fourier transform and an extending operation are performed on the restored image output by the image restoring network in the previous cascade to obtain corresponding to-be-complemented frequency-domain data. For example, a Fourier transform is performed on the restored image (that is, the restored image output by the image restoring network in the previous cascade) to obtain frequency-domain data corresponding to the restored image, and an extending operation is performed on the frequency-domain data corresponding to the restored image to obtain frequency-domain data after the extending operation. Then, frequency-domain information supplement is performed, by the frequency-domain complement network in the current cascade, on the to-be-complemented frequency-domain data (the frequency-domain data after the extending operation output by the image restoring network in the previous cascade) to obtain the frequency-domain complement data in the current cascade. If the frequency-domain complement network in the current cascade is not the last image processing network, the frequency-domain complement data in the current cascade is input to a susceptibility estimation network of a next image processing network for susceptibility supplement, and an inverse Fourier transform (F⁻) is performed on the frequency-domain complement data in the current cascade, then the frequency-domain complement data in the current cascade is input to an image restoring network in the next image processing network for image-domain information supplement.

A formula of the extending operation $\varepsilon$ is as follows:

$$\mathcal{E}(\mathbf{x}) = (S_1 x, \ldots, S_N x) \ldots \ldots \ldots \ldots (2)$$

$S_1, \ldots, S_N$ is susceptibility of the first radio frequency coil to an N$^{th}$ radio frequency coil. x is the frequency-domain data obtained by performing the Fourier transform on the restored image.

The susceptibility supplement is performed, by the susceptibility estimation network in the current cascade, on the frequency-domain complement data output by the frequency-domain complement network in the previous cascade to obtain the coil susceptibility in the current cascade. If the susceptibility estimation network in the current cascade is not located in the last image processing network, the coil susceptibility in the current cascade is input to an image restoring network of a next image processing network for image-domain information supplement.

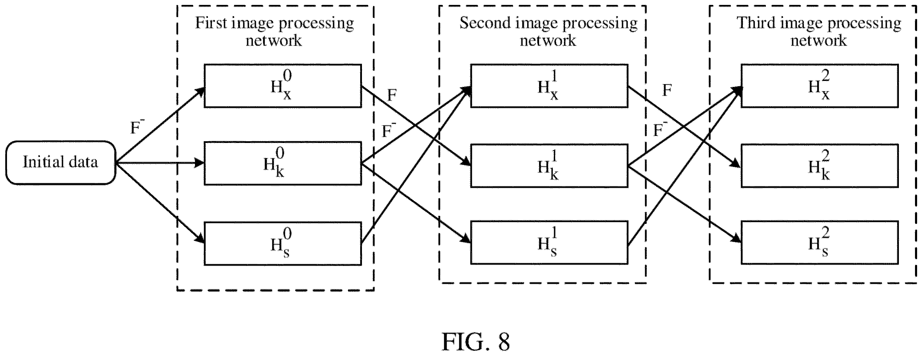

For example, as shown in FIG. 8, the first image processing network includes an image restoring network $H_x^0$, a frequency-domain complement network $H_k^0$, and a susceptibility estimation network $H_s^0$. The second image processing network includes an image restoring network $H_x^1$, a frequency-domain complement network $H_k^1$, and a susceptibility estimation network $H_s^1$. The third image processing network includes an image restoring network $H_x^2$, a frequency-domain complement network Hk, and a susceptibility estimation network $H_s^2$.

An inverse Fourier transform ($F^-$) and a shrinking operation are performed on frequency-domain complement data output by the frequency-domain complement network Hk in the first image processing network to obtain a time-domain image, and the time-domain image is input to the image restoring network $H_x^1$ in the second image processing network. Coil susceptibility output by the susceptibility estimation network $H_s^0$ in the first image processing network is input to the image restoring network $H_x^1$. The image restoring network $H_x^1$ obtains a restored image in a current cascade based on the input time-domain image and the coil susceptibility. A Fourier transform (F) and an extending operation are performed on the restored image in the current cascade, and the restored image in the current cascade is input to the frequency-domain complement network Hk in the third image processing network. For example, a Fourier transform is performed on the restored image in the current cascade to obtain frequency-domain data corresponding to the restored image in the current cascade, and an extending operation is performed on the frequency-domain data corresponding to the restored image in the current cascade to obtain spectral data after the extending operation.

A Fourier transform (F) and an extending operation are performed on a restored image output by the image restoring network $H_x^0$ in the first image processing network to obtain corresponding to-be-complemented frequency-domain data. Then, the to-be-complemented frequency-domain data is input to the frequency-domain complement network Hk in the second image processing network. The frequency-domain complement network Hk performs frequency-domain information supplement on the to-be-complemented frequency-domain data to obtain frequency-domain complement data in the current cascade. Then, the frequency-domain complement data in the current cascade is input to the susceptibility estimation network $H_s^2$ in the third image processing network, and an inverse Fourier transform ($F^-$) and a shrinking operation are performed on the frequency-domain complement data in the current cascade, then the frequency-domain complement data in the current cascade is input to the image restoring network $H_x^2$ in the third image processing network.

Susceptibility supplement is performed, by the susceptibility estimation network $H_s^1$ in the second image processing network, on the frequency-domain complement data output by the frequency-domain complement network Hk in the first image processing network to obtain coil susceptibility in a current cascade, and then the coil susceptibility in the current cascade is input to the image restoring network $H_x^2$ in the third image processing network.

In embodiments of this application, an information supplement operation is performed respectively on a plurality of pieces of obtained undersampled frequency-domain data by using a plurality of cascaded image processing networks to obtain corresponding target restored images, and a target reconstructed image is generated based on the plurality of obtained target restored images. In a process of obtaining the target restored images, an image restoring network, a frequency-domain complement network, and a susceptibility estimation network in the plurality of image processing networks perform cross information supplement in dimensions of an image domain, a frequency domain, and susceptibility information, to obtain more comprehensive image information. In this way, quality of the target reconstructed image is effectively improved when image reconstruction is performed based on the image information.

In all embodiments, a restored image output by an image restoring network in the last image processing network is used as the target restored image. Then, a residual sum of square (RSS) operation is performed on a plurality of target restored images to obtain a target reconstructed image, which is specifically shown in the following Formula (3):

$$\hat{\mathbf{x}} = \mathrm{RSS}(x_1, \dots, x_N) = \sqrt{\sum_{i=1}^{N} |x_i|^2} \dots\dots\dots\dots(3)$$

N represents a number of the radio frequency coils. $x_i$ represents a target restored image corresponding to the $i^{th}$ radio frequency coil.

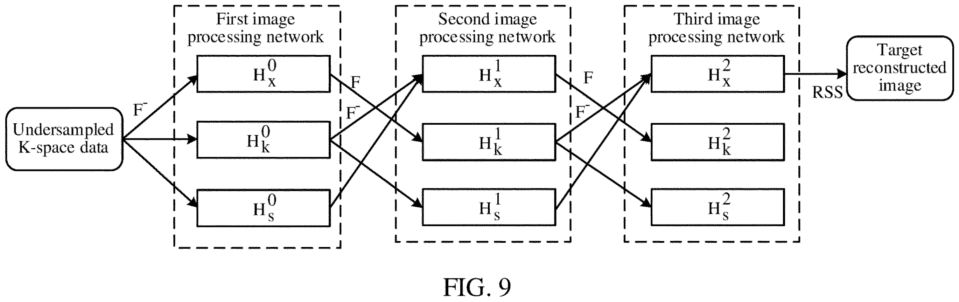

For example, as shown in FIG. 9, the first image processing network includes an image restoring network $H_x^0$, a frequency-domain complement network Hk, and a susceptibility estimation network $H_s^0$. The second image processing network includes an image restoring network $H_x^1$, a frequency-domain complement network $H_k^1$, and a susceptibility estimation network $H_s^1$. The third image processing network includes an image restoring network Hx, a frequency-domain complement network $H_k^2$, and a susceptibility estimation network $H_s^2$. The third image processing network is the last image processing network.

An inverse Fourier transform ($F^-$) is performed on undersampled K-space data to obtain a time-domain image corresponding to the undersampled K-space data. The time-domain image corresponding to the undersampled K-space data is input to the image restoring network $H_x^0$. After the image restoring network $H_x^0$ performs image-domain information supplement, a restored image in a first cascade is output. After a Fourier transform (F) is performed on the restored image in the first cascade to obtain frequency-domain data corresponding to the restored image in the first cascade, and the frequency-domain data corresponding to the restored image in the first cascade is input to the frequency-domain complement network $H_k^1$.

The undersampled K-space data is input to the frequency-domain complement network $H_k^0$ to obtain frequency-domain complement data in the first cascade. The frequency-domain complement data in the first cascade is input to the susceptibility estimation network $H_s^1$, and an inverse Fourier transform ($F^-$) is performed on the frequency-domain complement data in the first cascade to obtain a time-domain image corresponding to the frequency-domain complement data in the first cascade, and the time-domain image corresponding to the frequency-domain complement data in the first cascade is input to the image restoring network $H_x^1$.

Target frequency-domain data lower than a preset frequency is selected from the undersampled K-space data. Then, an inverse Fourier transform ($F^-$) is performed on the target frequency-domain data, and the target frequency-domain data is input to the susceptibility estimation network $H_s^0$ to obtain a time-domain image. The time-domain image is used as coil susceptibility in the first cascade, and the coil susceptibility in the first cascade is input to the image restoring network $H_x^1$.

The image restoring network $H_x^1$ obtains a restored image in a second cascade based on the frequency-domain complement data in the first cascade and the coil susceptibility in the first cascade. A Fourier transform (F) is performed on the restored image in the second cascade to obtain frequency-domain data corresponding to the restored image in the second cascade, and the frequency-domain data corresponding to the restored image in the second cascade is input to the frequency-domain complement network Hk.

After the frequency-domain complement network Hk performs frequency-domain information supplement on the frequency-domain data corresponding to the restored image in the second cascade, frequency-domain complement data in the second cascade is output. The frequency-domain complement data in the second cascade is input to the susceptibility estimation network $H_s^2$, and an inverse Fourier transform ($F^-$) is performed on the frequency-domain complement data in the second cascade to obtain a time-domain image corresponding to the frequency-domain complement data in the second cascade, and the time-domain image corresponding to the frequency-domain complement data in the second cascade is input to the image restoring network $H_x^2$.

After the susceptibility estimation network $H_s^1$ performs coil susceptibility supplement, coil susceptibility in the second cascade is output, and the coil susceptibility in the second cascade is input to the image restoring network $H_x^2$.

The image restoring network $H_x^2$ outputs a restored image in a third cascade based on the frequency-domain complement data in the second cascade and the coil susceptibility in the second cascade. Then, a residual sum of square operation on a plurality of restored images in a third cascade to obtain a target reconstructed image.

In embodiments of this application, after target restored images corresponding to a plurality of radio frequency coils are obtained, a residual sum of square operation is performed on the plurality of target restored images to obtain a target reconstructed image, so that image information in the target reconstructed image is distributed more evenly, thereby improving quality of the target reconstructed image.

After obtaining the target reconstructed image by the plurality of image processing networks is described, a joint training process of the plurality of image processing networks is described below, which includes the following operations: performing, based on an undersampled sample data set, joint iteration training on a plurality of cascaded to-be-trained processing networks to obtain the plurality of trained image processing networks, the following operations being performed in each iteration training: performing, by the plurality of to-be-trained processing networks, an information supplement operation respectively on a plurality of pieces of sample data selected from the sample data set to obtain a plurality of corresponding prediction restored images and a plurality of pieces of corresponding prediction frequency-domain complement data, and determining a prediction reconstructed image based on the plurality of obtained prediction restored images; and determining a target loss function based on the prediction reconstructed image and the plurality of pieces of obtained prediction frequency-domain complement data, and performing parameter adjustment by using the target loss function.

Specifically, the undersampled sample data is also undersampled K-space data of a human being or an animal. The plurality of pieces of sample data correspond to different radio frequency coils. In an end-to-end manner, a structural similarity (SSIM) loss function and a mean squared error (MSE) loss function are used for training. In a training process, after data in a form of a complex number in K-space and an image domain is divided into a real part and an imaginary part, the data is input to a real part input channel and an imaginary part input channel in the network respectively.

In all embodiments, a first loss function is determined based on the plurality of pieces of prediction frequency-domain complement data and fully-sampled sample data corresponding to the plurality of pieces of sample data, which is specifically shown in the following Formula (4):

$$\mathcal{L}_k = \sum\nolimits_{N_k} \||\boldsymbol{k}_n| - |\boldsymbol{k}_T|\|_2^2 \ldots \ldots \ldots (4)$$

$N_k$ is a number of samples in the sample data set. $\boldsymbol{k}_T$ represents prediction frequency-domain complement data output by a to-be-trained processing network in the last cascade. $\boldsymbol{k}_n$ represents the fully-sampled sample data (fully-sampled K-space data).

A second loss function is determined based on the prediction reconstructed image and a corresponding reference reconstructed image, which is specifically shown in the following Formula (5):

$$\mathcal{L}_x = \sum\nolimits_{N_x} (1 - SSIM(|\boldsymbol{x}_n|, |\boldsymbol{x}_T|)) \ldots \ldots \ldots (5)$$

$N_x$ is a number of sample images obtained by performing an inverse Fourier transform on the sample data in the sample data set. $\boldsymbol{x}_T$ represents the prediction reconstructed image. $\boldsymbol{x}_n$ represents the reference reconstructed image, and the reference reconstructed image is constructed based on the fully-sampled sample data.

The target loss function is determined based on the first loss function and the second loss function, which is specifically shown in the following Formula (6):

$$\mathcal{L}_s = \min_\theta \mathcal{L}_x + \mathcal{L}_k \ldots \ldots \ldots (6)$$

$\theta = \{\theta_x, \theta_k, \theta_s\}$ and $\theta_x$ represent network parameters in an image restoring network. $\theta_k$ represents a network parameter in a frequency-domain complement network. $\theta_s$ represents a network parameter in a susceptibility estimation network. $\mathcal{L}_s$ represents the target loss function.

For example, cascaded to-be-trained processing networks are set to 10. An image restoring network, a frequency-domain complement network, and a susceptibility estimation network in each to-be-trained processing network are U-net networks. The U-net network includes a compression path (also referred to as a downsampling path) and an extending path (also referred to as an upsampling path). The compression path includes four convolutional modules, and each convolutional module includes a pooling layer. The pooling layer is configured to perform a pooling operation, for example, maximum pooling or average pooling. In all embodiments, previous to the pooling layer, the pooling layer may alternatively include a two-dimensional convolution layer, an activation layer, and a normalization layer that are cascaded in sequence. A negative slope coefficient of the activation layer is 0.2, and a size of a convolution kernel of the two-dimensional convolution layer is $3 \times 3$.

A final output result of the compression path is referred to as a compression feature map or a downsampled feature map.

The extending path includes four convolutional modules, and each convolutional module includes an upsampling layer. In all embodiments, previous to the upsampling layer, a two-dimensional convolution layer, an activation layer, and a normalization layer that are cascaded in sequence may alternatively be provided. A negative slope coefficient of the activation layer is 0.2, and a size of a convolution kernel of the two-dimensional convolution layer is $3 \times 3$. A number of feature maps starts from 32, 32, and 4 respectively, and the number is doubled after a maximum pooling layer and halved after the upsampling layer. A final output result of the extending path is referred to as an upsampled feature map.

After the real part and the imaginary part are concatenated, the sample data in the form of a complex number in the K-space and the image domain are respectively input to the image restoring network, the frequency-domain complement network, and the susceptibility estimation network through the real part input channel and imaginary part input channel for operation. Then, a target loss value is calculated by using the foregoing Formula (6), and the target loss value is reversely transmitted to the plurality of cascaded to-be-trained processing networks. By updating the plurality of cascaded to-be-trained processing networks in a manner of minimizing the target loss value, the prediction reconstructed image is increasingly similar to the reference reconstructed image, and data difference between the prediction frequency-domain complement data and the fully-sampled sample data is increasingly small. In addition, to optimize an adjustment process of the network parameters, the network is optimized and trained by using an ADAM algorithm. An initial learning rate is $1.0 \times 10^{-4}$ and decreases with epochs. Each epoch refers to a process of training the to-be-trained processing network once by using all samples.

In embodiments of this application, an error of a frequency domain is determined based on a plurality of pieces of prediction frequency-domain complement data and fully-sampled sample data corresponding to a plurality of pieces of sample data, and an error of a time domain is determined based on a prediction reconstructed image and a corresponding reference reconstructed image. Then, a target loss function for adjusting a model parameter is obtained by combining the error of the frequency domain and the error of the time-domain. In this way, in a training process, a processing network gradually balances both time-domain prediction and frequency-domain prediction, so as to improve performance of training the obtained processing network.

In all embodiments, to balance generalization of a model to diverse data while ensuring prediction accuracy of the image processing network, regular terms are introduced in a model training process in embodiments of this application to ensure the image processing network.

Specifically, the frequency-domain complement network is trained by using the following Formula (7):

$$argmin_{\hat{k}}\left\|\boldsymbol{k} - \widehat{\boldsymbol{k}}\right\|_2^2 + \lambda_k\left\|\boldsymbol{x} - \mathcal{R} \circ \mathcal{F}^{-1}\big(\widehat{\boldsymbol{k}}\big)\right\|_2^2 \ldots\ldots\ldots (7)$$

$\boldsymbol{k}$ represents the fully-sampled sample data. $\widehat{\boldsymbol{k}}$ represents the prediction frequency-domain complement data. $\boldsymbol{x}$ represents the reference reconstructed image. $\mathcal{R}$ represents the shrinking operation. $\mathcal{F}^{-1}$ represents the inverse Fourier transform. $\lambda_k\|x - \mathcal{R} \circ \mathcal{F}^{-1}\big(\widehat{\boldsymbol{k}}\big)\|_2^2$ represents a regular term in training of the frequency-domain complement network.

The image restoring network is trained by using the following Formula (8):

$$argmin_{\hat{x}}\left\|\boldsymbol{x} - \widehat{\boldsymbol{x}}\right\|_2^2 + \lambda_x\left\|\widehat{\boldsymbol{k}} - M\mathcal{F} \circ \mathcal{E}(\widehat{\boldsymbol{x}})\right\|_2^2 \ldots\ldots\ldots (8)$$

$\boldsymbol{x}$ represents the reference reconstructed image. $\widehat{\boldsymbol{x}}$ represents the prediction reconstructed image. $M$ represents a sampling mask. $\varepsilon$ represents the extending operation. $\widehat{\boldsymbol{k}}$ represents the prediction frequency-domain complement data. $\mathcal{F}$ represents the Fourier transform. $\lambda_x\|\widehat{\boldsymbol{k}} - M\mathcal{F} \circ \mathcal{E}(\widehat{\boldsymbol{x}})\|_2^2$ represents a regular term corresponding to the image restoring network.

The susceptibility estimation network is trained by using the following Formula (9):

$$argmin_{\theta_s}\lambda_s\left\|\boldsymbol{s} - H_s(\tilde{\boldsymbol{s}}, \theta_s)\right\|_2^2 \ldots\ldots\ldots (9)$$

$\boldsymbol{s}$ represents real coil susceptibility. $\tilde{\boldsymbol{s}}$ represents prediction coil susceptibility. $\lambda_s\|\boldsymbol{s} - H_s(\tilde{\boldsymbol{s}}, \theta_s)\|_2^2$ represents a consistency term corresponding to the susceptibility estimation network.

In embodiments of this application, regular terms are introduced in a process of joint training of a frequency-domain complement network, an image restoring network, and a susceptibility estimation network, so as to improve generalization of a model to diverse data while ensuring prediction accuracy of a processing network.

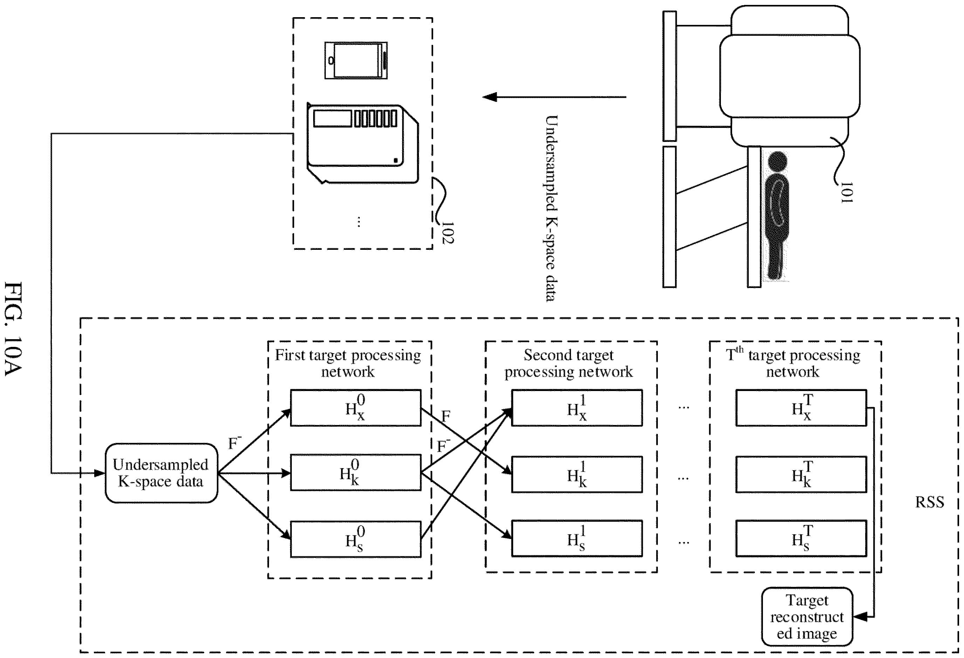

To better describe embodiments of this application, an image processing method according to an embodiment of this application is described below in combination with specific implementation scenarios. A process of the method may be performed by the signal collecting device 101 and the image reconstructing device 102 shown in FIG. 1. The signal collecting device 101 includes a nuclear magnetic resonance detecting frame, an examination table, and a plurality of RF coils, as shown in FIG. 10A. The method includes the following operations.

When a patient lies flat on the examination table, the plurality of RF coils are worn on corresponding examination parts of the patient, and then the examination table is controlled to move into an accommodating cavity of the nuclear magnetic resonance detecting frame. Then, each RF coil transmits a RF signal sequence of part of discrete phases to the patient according to a sampling mask, and receives corresponding undersampled K-space data, then sends a plurality of pieces of undersampled K-space data to the image reconstructing device 102. The image reconstructing device 102 includes T+1 image processing networks. The first image processing network includes an image restoring network $H_x^0$ , a frequency-domain complement network $H_k^0$, and a susceptibility estimation network $H_s^0$ ; the second image processing network includes an image restoring network $H_x^1$ , a frequency-domain complement network $H_k^1$, and a susceptibility estimation network $H_s^1$ ; ...; and a (T+1)$^{th}$ image processing network includes an image restoring network $H_x^T$ , a frequency-domain complement network $H_k^T$, and a susceptibility estimation network $H_s^T$ . A T$^{th}$ image processing network is the last image processing network. The image reconstructing device 102 divides the received plurality of pieces of undersampled K-space data into a plurality of groups (slices), and performs the following operations for the undersampled K-space data in each group.

An inverse Fourier transform (F$^-$) is performed on the undersampled K-space data to obtain a time-domain image corresponding to the undersampled K-space data. The time-domain image corresponding to the undersampled K-space data is input to the image restoring network $H_x^0$ . After the image restoring network $H_x^0$ performs image-domain information supplement, a restored image in a first cascade is output. A Fourier transform (F) is performed on the restored image in the first cascade to obtain frequency-domain data corresponding to the restored image in the first cascade, and the frequency-domain data of the restored image in the first cascade is input to the frequency-domain complement network $H_k^1$ .

The undersampled K-space data is input to the frequency-domain complement network Hk to obtain frequency-domain complement data in the first cascade. The frequency-domain complement data in the first cascade is input to the susceptibility estimation network $H_s^1$ , and an inverse Fourier transform (F$^-$) is performed on the frequency-domain complement data in the first cascade to obtain a time-domain image corresponding to the frequency-domain complement data in the first cascade, and the time-domain image corresponding to the frequency-domain complement data in the first cascade is input to the image restoring network $H_x^1$ .

Target frequency-domain data lower than a preset frequency is selected from the undersampled K-space data. Then, an inverse Fourier transform (F$^-$) is performed on the target frequency-domain data to obtain a time-domain image corresponding to the target frequency-domain data. The time-domain image corresponding to the target frequency-domain data is input to the susceptibility estimation network $H_s^0$ to obtain coil susceptibility in a first cascade, and the coil susceptibility in the first cascade is input to the image restoring network $H_x^1$.

The image restoring network $H_x^1$ obtains a restored image in a second cascade based on the frequency-domain complement data in the first cascade and the coil susceptibility in the first cascade. A Fourier transform (F) is performed on the restored image in the second cascade to obtain frequency-domain data corresponding to the restored image in the second cascade, and the frequency-domain data corresponding to the restored image in the second cascade is input to the frequency-domain complement network Hk .

After the frequency-domain complement network Hk performs frequency-domain information supplement, frequency-domain complement data in the second cascade is output. The frequency-domain complement data in the second cascade is input to the susceptibility estimation network $H_s^2$ , and an inverse Fourier transform (F$^-$) is performed on the frequency-domain complement data in the second cascade to obtain a time-domain image corresponding to the frequency-domain complement data in the second cascade, and the time-domain image corresponding to the frequency-domain complement data in the second cascade is input to the image restoring network $H_x^2$.

After the susceptibility estimation network $H_s^1$ performs coil susceptibility supplement, coil susceptibility in the second cascade is output, and the coil susceptibility in the second cascade is input to the image restoring network $H_x^2$.

By analogy, the image restoring network $H_x^T$ outputs a restored image in a $(T+1)^{th}$ cascade based on frequency-domain complement data in a $T^{th}$ cascade and coil susceptibility in a $T^{th}$ cascade. Then, a residual sum of square operation is performed on a plurality of restored images in the $(T+1)^{th}$ cascade to obtain two-dimensional anatomic images corresponding to a group (slice).

Two-dimensional anatomic images corresponding to a plurality of groups (slices) are combined to obtain a three-dimensional MRI image corresponding to an examination part. The three-dimensional MRI image may be configured for diagnosis of the examination part of the patient.

In embodiments of this application, an information supplement operation is performed respectively on a plurality of pieces of obtained undersampled frequency-domain data by using a plurality of cascaded image processing networks to obtain corresponding target restored images, and a target reconstructed image is generated based on the plurality of obtained target restored images. In a process of obtaining the target restored images, an image restoring network, a frequency-domain complement network, and a susceptibility estimation network in the plurality of image processing networks perform cross information supplement in dimensions of an image domain, a frequency domain, and susceptibility information, to obtain more comprehensive image information. In this way, quality of the target reconstructed image is effectively improved when image reconstruction is performed based on the more comprehensive image information that is obtained.

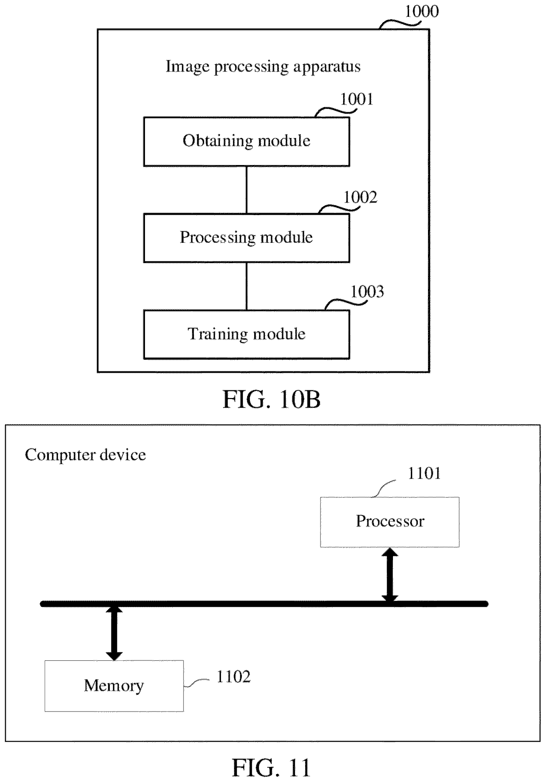

Based on the same technical concept, an embodiment of this application provides an image processing apparatus. As shown in FIG. 10B, the image processing apparatus 1000 includes: an obtaining module 1001, configured to: obtain, by a plurality of radio frequency coils, a plurality of pieces of corresponding undersampled frequency-domain data respectively; and a processing module 1002, configured to: perform, by using a plurality of cascaded image processing networks, an information supplement operation respectively on the plurality of pieces of obtained frequency-domain data to obtain a plurality of corresponding target restored images, and generate a target reconstructed image based on the plurality of target restored images, each of the cascaded image processing networks including an image restoring network, a frequency-domain complement network, and a susceptibility estimation network.

In the foregoing solution, the obtaining module 1001 is further configured to: perform the following operations on each piece of frequency-domain data in sequence according to a cascading order of the plurality of image processing networks: for the first image processing network, performing, by an image restoring network in a current cascade, image-domain information supplement on the frequency-domain data, and inputting an obtained restored image in the current cascade to a frequency-domain complement network in a next cascade for frequency-domain information supplement; and performing, by a frequency-domain complement network in the current cascade, frequency-domain information supplement on the frequency-domain data, and inputting obtained frequency-domain complement data in the current cascade to a susceptibility estimation network in the next cascade for susceptibility supplement; and for each non-first image processing network, performing, by an image restoring network in a current cascade, image-domain information supplement on frequency-domain complement data output by a frequency-domain complement network in a previous cascade and coil susceptibility output by a susceptibility estimation network in the previous cascade to obtain a restored image in the current cascade, and using the restored image in the current cascade output by an image processing network in the last cascade as the target reconstructed image.

In the foregoing solution, the processing module 1002 is further configured to: perform an inverse Fourier transform on the frequency-domain data to obtain an initial time-domain image; and perform, by the image restoring network in the current cascade, the image-domain information supplement on the initial time-domain image, and input the obtained restored image in the current cascade to the frequency-domain complement network in the next cascade for the frequency-domain information supplement.

In the foregoing solution, the processing module 1002 is further configured to: further perform the following operations for the first image processing network: selecting target data within a preset frequency range from the frequency-domain data, and performing an inverse Fourier transform on the target data to obtain initial coil susceptibility; and performing, by a susceptibility estimation network in the current cascade, susceptibility supplement on the initial coil susceptibility, and inputting obtained coil susceptibility in the current cascade to the frequency-domain complement network in the next cascade for frequency-domain information supplement.

In the foregoing solution, the processing module 1002 is further configured to: perform an inverse Fourier transform and a shrinking operation on the frequency-domain complement data output by the frequency-domain complement network in the previous cascade to obtain a time-domain image; and perform, by the image restoring network in the current cascade, the image-domain information supplement on the time-domain image and the coil susceptibility output by the susceptibility estimation network in the previous cascade to obtain the restored image in the current cascade.

In the foregoing solution, the processing module 1002 is further configured to: further perform the following operations for each non-first image processing network: performing, by a frequency-domain complement network in the current cascade, frequency-domain information supplement on a restored image output by an image restoring network in the previous cascade to obtain frequency-domain complement data in the current cascade; and performing, by a susceptibility estimation network in the current cascade, susceptibility supplement on the frequency-domain complement data output by the frequency-domain complement network in the previous cascade to obtain coil susceptibility in the current cascade.

In the foregoing solution, the processing module 1002 is further configured to: perform a Fourier transform and an extending operation on the restored image output by the image restoring network in the previous cascade to obtain corresponding to-be-complemented frequency-domain data; and perform, by the frequency-domain complement network in the current cascade, the frequency-domain information supplement on the to-be-complemented frequency-domain data to obtain the frequency-domain complement data in the current cascade.

In the foregoing solution, the processing module 1002 is further configured to: perform a residual sum of square operation on the obtained plurality of target restored images to obtain the target reconstructed image.

In the foregoing solution, the image processing apparatus further includes a training module 1003. The training module 1003 is further configured to: perform, based on an undersampled sample data set, joint iteration training on a plurality of cascaded to-be-trained processing networks to output the plurality of image processing networks, the following operations being performed in each iteration training: performing, by the plurality of to-be-trained processing networks, an information supplement operation respectively on a plurality of pieces of sample data selected from the sample data set to obtain corresponding prediction restored images and corresponding prediction frequency-domain complement data, and determining a prediction reconstructed image based on the plurality of obtained prediction restored images; and determining a target loss function based on the prediction reconstructed image and the plurality of pieces of obtained prediction frequency-domain complement data, and performing parameter adjustment by using the target loss function.

In the foregoing solution, the training module 1003 is further configured to: determine a first loss function based on the plurality of pieces of prediction frequency-domain complement data and fully-sampled sample data corresponding to the plurality of pieces of sample data; determine a second loss function based on the prediction reconstructed image and a corresponding reference reconstructed image, the reference reconstructed image being constructed based on the fully-sampled sample data; and determine the target loss function based on the first loss function and the second loss function.

In embodiments of this application, an information supplement operation is performed respectively on a plurality of pieces of obtained undersampled frequency-domain data by using a plurality of cascaded image processing networks to obtain corresponding target restored images, and a target reconstructed image is generated based on the plurality of obtained target restored images. In a process of obtaining the target restored images, an image restoring network, a frequency-domain complement network, and a susceptibility estimation network in the plurality of image processing networks perform cross information supplement in dimensions of an image domain, a frequency domain, and susceptibility information, to obtain more comprehensive image information. In this way, quality of the target reconstructed image is effectively improved when image reconstruction is performed based on the more comprehensive image information that is obtained.

Based on the same technical concept, an embodiment of this application provide a computer device. The computer device may be the image reconstructing device 102 shown in FIG. 1. As shown in FIG. 11, the computer device includes at least one processor 1101 and a memory 1102 connected to the at least one processor. A specific connection medium between the processor 1101 and the memory 1102 is not limited in this embodiment of this application. In FIG. 11, an example in which the processor 1101 and the memory 1102 are connected through a bus is used. The bus may include an address bus, a data bus, a control bus, and the like.

In this embodiment of this application, the memory 1102 stores instructions executed by the at least one processor 1101. The at least one processor 1101 may perform operations of the foregoing image processing method by executing the instructions stored in the memory 1102.

The processor 1101 is a control center of the computer device, and is connected to various parts of the computer device by using various interfaces and lines. By running or executing the instructions stored in the memory 1102, the processor invokes data stored in the memory 1102, to perform MRI image reconstruction. In all embodiments, the processor 1101 may include one or more processing units. The processor 1101 may integrate an application processor and a modem processor. The application processor mainly processes an operating system, a user interface, an application program, and the like. The modem processor mainly processes wireless communication. The foregoing modem processor may alternatively not be integrated into the processor 1101. In all embodiments, the processor 1101 and the memory 1102 may be implemented on the same chip. In all embodiments, the processor and the memory may be separately implemented on an independent chip.

The processor 1101 may be a general purpose processor, for example, a central processing unit (CPU), a digital signal processor, an application specific integrated circuit (ASIC), a field programmable gate array, or another programmable logic device, a discrete gate or a transistor logic device, or a discrete hardware component, and may implement or perform the methods, operations, and logical block diagrams disclosed in embodiments of this application. The general purpose processor may be a microprocessor, any conventional processor, or the like. The operations of the method disclosed with reference to embodiments of this application may be directly implemented by a hardware processor, or may be implemented by a combination of hardware and software modules in the processor.

As a non-volatile computer-readable storage medium, the memory 1102 may be configured to store non-volatile software programs, non-volatile computer-executable programs, and modules. The memory 1102 may include at least one type of storage medium, for example, a flash memory, a hard disk, a multimedia card, a card-type memory, a random access memory (RAM), a static random access memory (SRAM), a programmable read only memory (PROM), a read only memory (ROM), an electrically erasable programmable read only memory (EEPROM), a magnetic memory, a magnetic disk, and an optical disc. The memory 1102 is any other medium that can be configured to carry or store expected program codes in a form of instructions or data structures and that can be accessed by a computer device, but is not limited thereto. The memory 1102 in this embodiment of this application may alternatively be a circuit or any other apparatus capable of realizing a storage function, and is configured to store program instructions and/or data.

An embodiment of this application provides a computer-readable storage medium, having a computer program stored thereon, the computer program being executable by a computer device, and the program, when run on the computer device, causing the computer device to perform operations of the foregoing image processing method.

An embodiment of this application provides a computer program product, including a computer program stored on a computer-readable storage medium, the computer program product including program instructions, and the program instructions, when executed by a computer device, causing the computer device to perform operations of the foregoing image processing method.

A person skilled in the art may understand that embodiments of this application may be provided as a method or a computer program product. Therefore, this application may use a form of hardware-only embodiments, software-only embodiments, or embodiments with a combination of software and hardware. Moreover, this application may use a form of a computer program product that is implemented on one or more computer-usable storage media (including but not limited to a disk memory, a CD-ROM, an optical memory, and the like) that include computer-usable program code.

This application is described with reference to flowcharts and/or block diagrams of the method, the device (system), and the computer program product according to embodiments of this application. Computer program instructions can implement each procedure and/or block in the flowcharts and/or block diagrams and a combination of procedures and/or blocks in the flowcharts and/or block diagrams. These computer program instructions may be provided to a general purpose computer, a special-purpose computer, an embedded processor, or a processor of another programmable data processing device to generate a machine, so that an apparatus configured to implement functions specified in one or more procedures in the flowcharts and/or one or more blocks in the block diagrams is generated by using instructions executed by the computer device or the processor of another programmable data processing device.

These computer program instructions may alternatively be stored in a computer-readable memory that can instruct a computer device or another programmable data processing device to work in a specific manner, so that the instructions stored in the computer-readable memory generate an artifact that includes an instruction apparatus. The instruction apparatus implements a specific function in one or more procedures in the flowcharts and/or in one or more blocks in the block diagrams.

These computer program instructions may alternatively be loaded onto a computer device or another programmable data processing device, so that a series of operations and steps are performed on the computer device or another programmable device, thereby generating computer device-implemented processing. Therefore, the instructions executed on the computer device or another programmable device provide operations for implementing a specific function in one or more processes in the flowcharts and/or in one or more blocks in the block diagrams.

Although exemplary embodiments of this application have been described, knowing the basic creative concept, a person skilled in the art can make additional changes and modifications to these embodiments. Therefore, the following claims are intended to be construed as to cover the exemplary embodiments and all changes and modifications falling within the scope of this application.

Clearly, a person skilled in the art can make various modifications and variations to this application without departing from the spirit and scope of this application. In this case, if the modifications and variations made to this application fall within the scope of the claims of this application and their equivalent technologies, this application is intended to include these modifications and variations.

## Claims

1. An image processing method, executable by an electronic device, the method comprising:

obtaining, by a plurality of radio frequency coils, a plurality of pieces of undersampled frequency-domain data respectively, each radio frequency coil being configured to obtain one piece of undersampled frequency-domain data;

performing, by using a plurality of cascaded image processing networks, an information supplement operation respectively on the plurality of pieces of undersampled frequency-domain data to obtain a plurality of corresponding target restored images, each target restored image being obtained from a respective piece of frequency-domain data, and each of the cascaded image processing networks comprising an image restoring network, a frequency-domain complement network, and a susceptibility estimation network; and

generating a target reconstructed image based on the plurality of target restored images.

2. The method according to claim 1, wherein the performing, by using a plurality of cascaded image processing networks, an information supplement operation respectively on the plurality of pieces of undersampled frequency-domain data to obtain a plurality of corresponding target restored images comprises:

performing the following operations on each piece of frequency-domain data in sequence according to a cascading order of the plurality of image processing networks:

for the first image processing network, performing, by an image restoring network in a current cascade, image-domain information supplement on the frequency-domain data, and inputting an obtained restored image in the current cascade to a frequency-domain complement network in a next cascade for frequency-domain information supplement; and performing, by a frequency-domain complement network in the current cascade, frequency-domain information supplement on the frequency-domain data, and inputting obtained frequency-domain complement data in the current cascade to a susceptibility estimation network in the next cascade for susceptibility supplement; and

for each non-first image processing network, performing, by an image restoring network in a current cascade, image-domain information supplement on frequency-domain complement data output by a frequency-domain complement network in a previous cascade and coil susceptibility output by a susceptibility estimation network in the previous cascade to obtain a restored image in the current cascade, and using the restored image in the current cascade output by an image processing network in the last cascade as the target reconstructed image.

3. The method according to claim 2, wherein the performing, by an image restoring network in a current cascade, image-domain information supplement on the frequency-domain data, and inputting an obtained restored image in the current cascade to a frequency-domain complement network in a next cascade for frequency-domain information supplement comprises:

performing an inverse Fourier transform on the frequency-domain data to obtain an initial time-domain image; and performing, by the image restoring network in the current cascade, the image-domain information supplement on the initial time-domain image, and inputting the obtained restored image in the current cascade to the frequency-domain complement network in the next cascade for the frequency-domain information supplement.

4. The method according to claim 3, wherein the performing, by the image restoring network in the current cascade, the image-domain information supplement on the initial time-domain image comprises:
performing, by the image restoring network in the current cascade, the following processing on the initial time-domain image:

performing a pooling operation on the initial time-domain image to obtain a pooled feature map; and performing upsampling on a downsampled feature map to obtain an upsampled feature map, and using the upsampling feature map as the obtained restored image in the current cascade.

5. The method according to any one of claims 2 to 4, wherein the method further comprises:
performing the following operations for the first image processing network:

selecting target data within a preset frequency range from the frequency-domain data, and performing an inverse Fourier transform on the target data to obtain initial coil susceptibility; and performing, by a susceptibility estimation network in the current cascade, susceptibility supplement on the initial coil susceptibility, and inputting obtained coil susceptibility in the current cascade to the frequency-domain complement network in the next cascade for frequency-domain information supplement.

6. The method according to any one of claims 2 to 5, wherein the performing, by an image restoring network in a current cascade, image-domain information supplement on frequency-domain complement data output by a frequency-domain complement network in a previous cascade and coil susceptibility output by a susceptibility estimation network in the previous cascade to obtain a restored image in the current cascade comprises:

performing an inverse Fourier transform and a shrinking operation on the frequency-domain complement data output by the frequency-domain complement network in the previous cascade to obtain a time-domain image; and performing, by the image restoring network in the current cascade, the image-domain information supplement on the time-domain image and the coil susceptibility output by the susceptibility estimation network in the previous cascade to obtain the restored image in the current cascade.

7. The method according to any one of claims 2 to 6, wherein the method further comprises:
performing the following operations for each non-first image processing network:

performing, by a frequency-domain complement network in the current cascade, frequency-domain information supplement on a restored image output by an image restoring network in the previous cascade to obtain frequency-domain complement data in the current cascade; and
performing, by a susceptibility estimation network in the current cascade, susceptibility supplement on the frequency-domain complement data output by the frequency-domain complement network in the previous cascade to obtain coil susceptibility in the current cascade.

8. The method according to claim 7, wherein the performing, by a frequency-domain complement network in the current cascade, frequency-domain information supplement on a restored image output by an image restoring network in the previous cascade to obtain frequency-domain complement data in the current cascade comprises:

performing a Fourier transform and an extending operation on the restored image output by the image restoring network in the previous cascade to obtain corresponding to-be-complemented frequency-domain data; and
performing, by the frequency-domain complement network in the current cascade, the frequency-domain information supplement on the to-be-complemented frequency-domain data to obtain the frequency-domain complement data in the current cascade.

9. The method according to any one of claims 1 to 8, wherein the generating a target reconstructed image based on the plurality of target restored images comprises:
performing a residual sum of square operation on the obtained plurality of target restored images to obtain the target reconstructed image.

10. The method according to any one of claims 1 to 9, wherein the method further comprises:
performing joint training by using the following manners to obtain the plurality of image processing networks:
performing, based on an undersampled sample data set, joint iteration training on a plurality of cascaded to-be-trained processing networks to obtain the plurality of image processing networks, the following operations being performed in each iteration training:

performing, by the plurality of to-be-trained processing networks, an information supplement operation respectively on a plurality of pieces of sample data selected from the sample data set to obtain a plurality of corresponding prediction restored images and a plurality of pieces of corresponding prediction frequency-domain complement data, and determining a prediction reconstructed image based on the plurality of prediction restored images; and determining a target loss function based on the prediction reconstructed image and the plurality of pieces of prediction frequency-domain complement data, and performing parameter adjustment by using the target loss function.

11. The method according to claim 10, wherein the determining a target loss function based on the prediction reconstructed image and the plurality of pieces of prediction frequency-domain complement data comprises:

determining a first loss function based on the plurality of pieces of prediction frequency-domain complement data and fully-sampled sample data corresponding to the plurality of pieces of sample data;
determining a second loss function based on the prediction reconstructed image and a corresponding reference reconstructed image, the reference reconstructed image being constructed based on the fully-sampled sample data; and
determining the target loss function based on the first loss function and the second loss function.

**12.** An image processing apparatus, comprising:

an obtaining module, configured to: obtain, by a plurality of radio frequency coils, a plurality of pieces of undersampled frequency-domain data respectively, each radio frequency coil being configured to obtain one piece of undersampled frequency-domain data; and
a processing module, configured to: perform, by using a plurality of cascaded image processing networks, an information supplement operation respectively on the plurality of pieces of obtained frequency-domain data to obtain a plurality of corresponding target restored images, and generate a target reconstructed image based on the plurality of target restored images, each target restored image being obtained from a respective piece of frequency-domain data, and each of the cascaded image processing networks comprising an image restoring network, a frequency-domain complement network, and a susceptibility estimation network.

**13.** A computer device, comprising a memory, a processor, and a computer program stored in the memory and executable on the processor, the processor, when executing the program, implementing operations of the method according to any one of claims 1 to 11.

**14.** A computer-readable storage medium, having a computer program stored thereon, the computer program being executable by a computer device, and the program, when run on the computer device, causing the computer device to perform operations of the method according to any one of claims 1 to 11.

**15.** A computer program product, comprising a computer program stored on a computer-readable storage medium, the computer program product comprising program instructions, and the program instructions, when executed by a computer device, causing the computer device to perform operations of the method according to any one of claims 1 to 11.

FIG. 1

Obtain, by a plurality of receiving coils, corresponding undersampled initial data respectively

S201

Perform, by using a plurality of cascaded target processing networks, an information supplement operation respectively on the plurality of undersampled pieces of obtained initial data to obtain corresponding target restored images, and generate a target reconstructed image based on the plurality of obtained target restored images

S202

FIG. 2

Image processing network

Image restoring network

Frequency-domain complement network

Susceptibility estimation network

Image processing network

Image restoring network

Frequency-domain complement network

Susceptibility estimation network

...

Image processing network

Image restoring network

Frequency-domain complement network

Susceptibility estimation network

FIG. 3

First image processing network

Image restoring network

Frequency-domain complement network

Susceptibility estimation network

Second image processing network

Image restoring network

Frequency-domain complement network

Susceptibility estimation network

Initial data

$F^-$

$F$

$F^-$

FIG. 4

First image
processing network

Image restoring
network

$F^-$

$F$

$F^-$

Initial data

Frequency-domain
complement network

Susceptibility
estimation network

Second image
processing network

Image restoring
network

Frequency-domain
complement network

Susceptibility
estimation network

FIG. 5

First image
processing network

$H_x^0$

$F$

$F^-$

$F^-$

Undersampled
K-space data

$H_k^0$

$H_s^0$

Second image
processing network

$H_x^1$

$H_k^1$

$H_s^1$

FIG. 6

FIG. 7

FIG. 8

FIG. 9

EP 4 443 382 A1

FIG. 10A

1000

Image processing apparatus

1001

Obtaining module

1002

Processing module

1003

Training module

## FIG. 10B

Computer device

1101

Processor

1102

Memory

## FIG. 11

## INTERNATIONAL SEARCH REPORT

| | International application No. |
|---|---|
| | **PCT/CN2023/095109** |

**A. CLASSIFICATION OF SUBJECT MATTER**

G06T 5/00(2006.01)i; G06T 5/10(2006.01)i; G06N 3/04(2023.01)i; G06N 3/08(2023.01)i

According to International Patent Classification (IPC) or to both national classification and IPC

**B. FIELDS SEARCHED**

Minimum documentation searched (classification system followed by classification symbols)

IPC: G06T G06N

Documentation searched other than minimum documentation to the extent that such documents are included in the fields searched

Electronic data base consulted during the international search (name of data base and, where practicable, search terms used)

CNABS; CNTXT; CNKI; VEN; DWPI; USTXT; WOTXT; EPTXT: 欠采样, K空间, 数据, 恢复, 复原, 补充, 敏感度, 重建, 神经网络, undersampling, K space, data, recovery, complement, compensation, sensitivity, restore, neural network

**C. DOCUMENTS CONSIDERED TO BE RELEVANT**

| Category* | Citation of document, with indication, where appropriate, of the relevant passages | Relevant to claim No. |
|---|---|---|
| PX | CN 115222628 A (TENCENT TECHNOLOGY (SHENZHEN) CO., LTD.) 21 October 2022 (2022-10-21) claims 1-13, and description, paragraphs [0061]-[0203] | 1-15 |
| Y | CN 114529473 A (SHENZHEN LIANYING HIGH-END MEDICAL EQUIPMENT INNOVATION INSTITUTE) 24 May 2022 (2022-05-24) description, paragraphs [0064]-[0164] | 1, 9-15 |
| A | CN 114529473 A (SHENZHEN LIANYING HIGH-END MEDICAL EQUIPMENT INNOVATION INSTITUTE) 24 May 2022 (2022-05-24) description, paragraphs [0064]-[0164] | 2-8 |
| A | CN 113592973 A (HARBIN INSTITUTE OF TECHNOLOGY, SHENZHEN) 02 November 2021 (2021-11-02) entire document | 1-15 |

☑ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **18 July 2023** | **03 August 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
|---|
| **PCT/CN2023/095109** |

### C. DOCUMENTS CONSIDERED TO BE RELEVANT

| Category* | Citation of document, with indication, where appropriate, of the relevant passages | Relevant to claim No. |
|---|---|---|
| Y | 李钊 (LI, Zhao). "基于深度学习的磁共振图像重建和波谱相位校正方法研究 (Non-official translation: Research on Deep Learning-based Magnetic Resonance Image Reconstruction and Spectral Phase Correction Methods)"<br>中国博士学位论文全文数据库(信息科技辑) (Information Science & Technology, China Doctoral Dissertations Full-Text Database), No. 1, 15 January 2022 (2022-01-15), ISSN: 1674-022X,<br>pages 28-34 | 1, 9-15 |
| A | 李钊 (LI, Zhao). "基于深度学习的磁共振图像重建和波谱相位校正方法研究 (Non-official translation: Research on Deep Learning-based Magnetic Resonance Image Reconstruction and Spectral Phase Correction Methods)"<br>中国博士学位论文全文数据库(信息科技辑) (Information Science & Technology, China Doctoral Dissertations Full-Text Database), No. 1, 15 January 2022 (2022-01-15), ISSN: 1674-022X,<br>pages 28-34 | 2-8 |

Form PCT/ISA/210 (second sheet) (July 2022)

## INTERNATIONAL SEARCH REPORT
### Information on patent family members

| Patent document cited in search report | | | Publication date (day/month/year) | Patent family member(s) | | | Publication date (day/month/year) |
|---|---|---|---|---|---|---|---|
| CN | 115222628 | A | 21 October 2022 | HK | 40075331 | A0 | 20 January 2023 |
| CN | 114529473 | A | 24 May 2022 | None | | | |
| CN | 113592973 | A | 02 November 2021 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210876986